# FASCICULE DE BREVET EUROPEEN

(11) **EP 0 392 907 B1**
(45) Date de publication et mention de la délivrance du brevet: **10.01.1996**
(21) Numéro de dépôt: 90400951.1
(22) Date de dépôt: 06.04.1990
(51) Int. Cl.: G11B 5/31

(54) **Procédé de réalisation d'un dispositif utilisant une structure de films à couches minces**
Herstellungsverfahren für eine Vorrichtung mit Dünnschicht-Filmstruktur
Process for producing a device using a thin layer film structure

(30) Priorité: 14.04.1989 FR 8904966
(43) Date de publication de la demande: 17.10.1990
(73) Titulaire: COMPAGNIE EUROPEENNE DE COMPOSANTS ELECTRONIQUES LCC, F-92400 Courbevoie (FR)
(72) Inventeur: Coutellier, Jean-Marc, F-92045 Paris la Défense (FR); Jacobelli, Alain, F-92045 Paris la Défense (FR); Maurice, François, F-92045 Paris la Défense (FR); Meunier, Paul-Louis, F-92045 Paris la Défense (FR)
(74) Mandataire: Guérin, Michel

(56) Documents cités:
- DE-A- 2 114 930
- FR-A- 1 159 994
- JP-A- 1 027 008
- IEDM 85, Technical Digest 1985, IEEE, NEW YORK, USA pages 688 - 691; T. Hamaguchi et al.: "NOVEL LSI/SOI WAFER FABRICATION USING DEVICE LAYER TRANSFER
- TECHNIQUE"
- PATENT ABSTRACTS OF JAPAN vol. 9, no. 239 (P-391)(1962) 25 septembre 1985, & JP-A- 60 093610 (MATSUSHITA DENKI SANGYO K.K.) 25 mai 1985,
- PATENT ABSTRACTS OF JAPAN vol. 6, no. 30 (P-103)(908) 23 février 1982, & JP-A- 56 148713 (FUJITSU K.K.) 18 novembre 1981,

## Description

L'invention se rapporte à un dispositif formé d'au moins deux parties solidarisées l'une à l'autre, et dont l'une des parties est faite d'une structure du type films à couches minces. L'invention peut s'appliquer de manière intéressante particulièrement (mais non exclusivement) à la fabrication des têtes magnétiques hybrides notamment à structure planaire, c'est-à-dire de têtes magnétiques constituées d'une part, d'un corps principal (formant l'une des parties) en une ou plusieurs pièces assemblées (en ferrite par exemple) et formant un circuit magnétique de fermeture de champ (pouvant porter de manière classique un ou des bobinages) ; et constituées d'autre part, d'une structure (formant l'autre partie) montée sur le corps principal, cette structure étant formée par des films à couches minces agencés pour constituer les pôles séparés par un entrefer qui forment la face active de la tête magnétique.

Les techniques de fabrication des substrats qui forment un circuit magnétique sont bien connues et décrites notamment dans des demandes de brevet français n° 86 14974 , n° 88 08526, n° 87 14824, n° 88 08527.

Dans le brevet FR-A-1.159.994 est décrite une fabrication de circuit magnétique n'utilisant pas une technologie de dépôts de films en couche mince mais utilisant une technologie de pièces rapportées les unes sur les autres, avec des pièces polaires collées sur une pièce métallique intermédiaire elle-même collée sur un circuit magnétique principal.

D'autre part, on trouve, dans des demandes de brevets français n° 87 14824 et n° 86 14974 , un exemple de réalisation de faces actives pour têtes magnétiques, par la technologie des films en couches minces. La demande de brevet français n° 8614974 correspond au brevet européen EP-A-270404. Le préambule de la revendication 1 est basé sur ce document.

Comme il est indiqué dans la dernière citée de ces demandes de brevets (n° 86 14974), en plus de l'amélioration des caractéristiques utiles à une tête magnétique d'enregistrement et/ou lecture, ce type de tête magnétique se prête à une réalisation en grande série, d'où il résulte une réduction considérable des coûts.

En effet, une pluralité de telles têtes magnétiques peuvent être réalisées simultanément sur un même substrat qui est ensuite découpé pour former des têtes magnétiques individuelles.

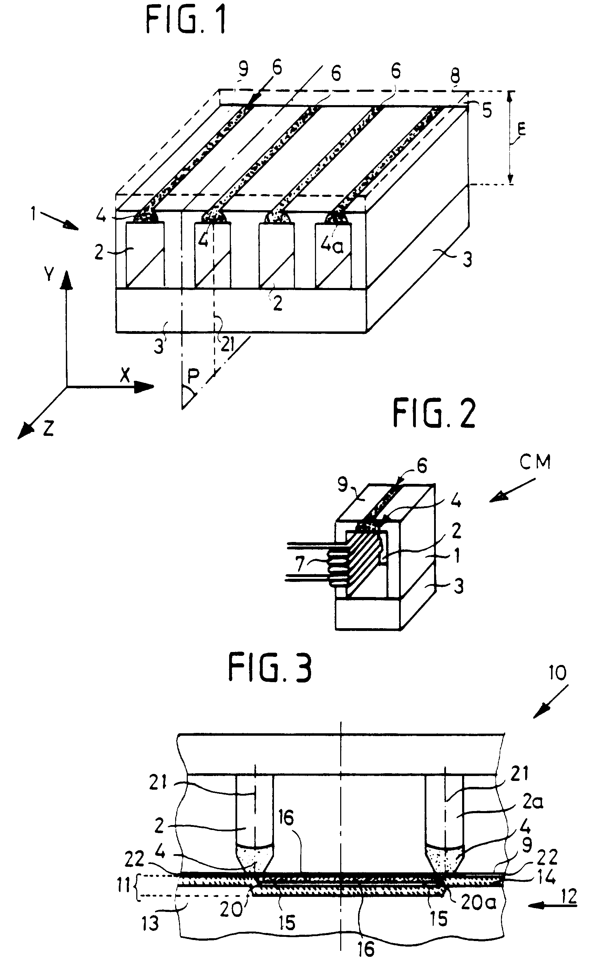

La figure 1 représente un exemple d'un substrat comme ci-dessus mentionné, qui en lui-même fait l'objet d'une demande de brevet n° 87 14824, et qui est décrit ci-après pour une suffisance de description, cette demande de brevet n'ayant pas encore été publiée.

La figure 1 est une vue en perspective qui montre un ensemble destiné à former simultanément une pluralité de têtes magnétiques. Cet ensemble est réalisé dans un substrat 1 en matériau magnétique (un bloc de ferrite par exemple). Le substrat 1 comporte une plaque 3 rapportée, en matériau magnétique, et alors que cette plaque 3 n'est pas encore rapportée sur le substrat 1, on réalise dans ce dernier des encoches parallèles 2, suivant l'épaisseur E du substrat 1 ; et on réalise au fond de chaque encoche un rétrécissement 4, de telle sorte qu'une encoche plus un rétrécissement n'atteignent pas une face 8 du substrat 1 opposée à la plaque 3.

Ensuite, les rétrécissements 4 sont remplis d'un matériau non magnétique, on coule par exemple un matériau à base de verre.

Puis la plaque 3 est fixée au substrat 1 et enfin on usine le substrat 1 par la face 8 pour ôter une partie 5 (montrée en traits pointillés) de ce dernier opposée à la plaque 3 jusqu'à faire apparaître les rétrécissements 4 sur une nouvelle face 9 et on usine jusqu'à obtenir des entrefers 6 (formés du matériau non magnétique) ayant la largeur désirée. Bien entendu, les rétrécissements 4 peuvent avoir la forme d'un triangle comme montré en traits pointillés pour le rétrécissement 4a.

Ensuite, on découpe la structure ainsi réalisée en circuits magnétiques individuels, La découpe se fait selon des plans tels que P situés entre les encoches et parallèles à l'axe des encoches ; la structure de la figure 1 étant placée dans un trièdre XYZ, avec les faces 10 et 11 parallèles au plan XZ, les plans tels que P sont parallèles au plan ZY.

Ensuite, on découpe également, selon des plans non représentés, parallèles au plan YX.

Au cours d'une étape ultérieure, chaque circuit magnétique CM est équipé d'un bobinage 7 tel que cela est représenté en figure 2. Ce bobinage est bobiné par l'encoche 2 autour d'une branche du circuit magnétique CM.

Dans le cas d'une tête magnétique en couches minces la face active 9 comportant l'entrefer 6 est revêtue d'une couche (non représentée) d'un matériau fortement magnétique tel que celui connu sous le nom de Sendust (Feₓ Si_{y} Al_{z}). Cette opération peut également être faite avant les découpes en circuits magnétiques individuels. Ce revêtement de matériau fortement magnétique recouvre la face 9 et une partie de l'entrefer 6 de chaque circuit magnétique, de sorte à constituer les 2 pôles de la tête magnétique.

Ainsi le substrat à partir duquel est formé le circuit magnétique de fermeture de champ constitue d'une manière plus générale un substrat d'accueil de la ou des couches minces.

Quelle que soit la technologie à base de film à couche mince qui est mise en oeuvre pour réaliser la face active de la tête magnétique, suivant par exemple l'enseignement de l'une ou l'autre des deux demandes de brevets ci-dessus citées ; cette technologie présente des inconvénients importants tels que ci-après mentionnés :
- la face du substrat destiné à recevoir la ou les couches minces, c'est-à-dire le substrat qui constitue le circuit magnétique, doit être parfaitement polie pour présenter une qualité de surface compatible avec le dépôt des couches minces,
- de plus, il est difficile d'obtenir le poli recherché de la face du substrat sans créer une différence de hauteur entre la face en ferrite (qui est dure) et le matériau non magnétique en verre par exemple (contenu dans les rétrécissements 4) qui constitue l'entrefer macroscopique et qui est moins dur. D'où il résulte la formation d'une zone de fracture qui altère la qualité de la couche mince,
- il est souvent nécessaire de recuire les couches minces magnétiques déposées sur le substrat formant le circuit magnétique ou substrat de fermeture de champ, or les températures de recuit peuvent être incompatibles avec les matériaux utilisés avec ou pour réaliser ce substrat (ferrite constituant le circuit magnétique, verre ou autre substance non magnétique assurant le collage des pièces ferrite et le remplissage de l'entrefer macroscopique),
- les pôles magnétiques sont définis par gravure lors des dernières étapes de réalisation. La surface active de la tête n'est donc pas plane puisque les pôles émergent de la surface du substrat en ferrite. Aussi, lorsqu'une couche anti-usure doit être déposée à la surface de la tête, les arêtes des bords des pôles constituent des points de fragilité pour cette couche.

L'invention concerne un procédé qui permet d'éviter ces inconvénients et bien entendu l'invention peut s'appliquer non seulement au cas particulier de la réalisation de têtes magnétiques à couches minces qui a été décrite à titre d'exemple, mais aussi à tous les cas où l'on désire réaliser un dispositif en au moins deux parties, dont l'une comporte au moins une couche mince, et dont l'autre constitue un substrat d'accueil à cette couche mince. Le procédé selon l'invention est spécifié dans la revendication 1.

L'invention sera mieux comprise et d'autres avantages qu'elle procure apparaîtront à la lecture de la description qui suit, faite à titre d'exemple non limitatif en référence aux figures annexées, parmi lesquelles :
- la figure 1 déjà décrite, montre un substrat connu en matériau magnétique servant à la réalisation d'une pluralité de têtes magnétiques et pouvant constituer un substrat d'accueil à une ou des couches minces,
- la figure 2 déjà décrite montre un circuit magnétique connu, obtenu par découpe du substrat montré à la figure 1,
- la figure 3 illustre schématiquement une étape caractéristique du procédé de l'invention et montre, par une vue schématique en coupe, un substrat d'accueil, semblable à celui montré à la figure 2, et un ensemble intermédiaire rapporté sur le substrat d'accueil,
- les figures 4a et 4b sont des vues en coupe montrant schématiquement un substrat intermédiaire représenté à la figure 3, avant et après une étape de gravure ;
- la figure 5 est une vue en coupe montrant schématiquement le substrat intermédiaire recouvert de trois couches minces ;
- la figure 6 est une vue en coupe montrant schématiquement le substrat intermédiaire de la figure 5 après une étape de polissage destinée à faire apparaître un entrefer ;
- la figure 7 est une vue en coupe montrant schématiquement le substrat d'accueil recouvert de deux couches minces magnétiques situées dans un même plan et séparées par un entrefer, et formant une ébauche de tête magnétique après élimination du substrat intermédiaire ;
- la figure 8 illustre à titre d'exemple non limitatif, une forme à conférer aux pôles d'une tête magnétique ;
- les figures 9a, 9b illustrent une étape du procédé se rapportant à une opération de masquage et de gravure relative à un premier pôle magnétique, dans une version préférée de l'invention qui permet de former les pôles magnétiques sur l'ensemble intermédiaire, c'est-à-dire avant élimination du support intermédiaire ;
- les figures 10a, 10b illustrent schématiquement une étape de masquage et gravure relative aux deux pôles magnétiques ;
- la figure 11 illustre schématiquement les dépôts successifs de trois couches minces sur le substrat intermédiaire et illustre le résultat d'un polissage qui fait apparaître directement les deux pôles magnétiques séparés par l'entrefer ;
- la figure 12 représente l'ensemble intermédiaire après une étape de polissage ou arasement de la structure à couches minces montrée à la figure 11 ;
- la figure 13 illustre schématiquement l'étape dans laquelle l'ensemble intermédiaire est rapporté sur le substrat d'accueil dans la version préférée du procédé de l'invention ;
- la figure 14 représente schématiquement le substrat d'accueil portant la structure à couche mince, après élimination du substrat intermédiaire.

A titre d'exemple non limitatif, la figure 3 illustre une application de l'invention à la réalisation de têtes magnétiques de lecture et/ou écriture.

La figure 3 représente un substrat d'accueil 10 constitué par un support ou substrat en matériau magnétique semblable au substrat montré à la figure 1, vu par une coupe selon le plan Y - X de la figure 1. Dans l'exemple de la figure 3 seulement deux encoches 2, 2a sont représentées correspondant chacune à une rangée de têtes magnétiques, ces deux rangées étant séparées par découpe à la fin du procédé selon une ligne en traits pointillés ; et toutes les têtes magnétiques sont individualisées par découpage comme il a été mentionné dans le préambule.

La figure 3 montre en outre une structure il avec un ou des films en couches minces. La structure 11 à couches minces est formée sur un substrat appelé substrat intermédiaire 13 dans la suite de la description, avec lequel la structure 11 à couches minces constitue un ensemble intermédiaire 12.

Ceci illustre une caractéristique importante du procédé de l'invention, qui consiste à réaliser au moins partiellement la structure 11 à couches minces sur un substrat différent de celui qui est destiné à recevoir en définitive cette structure, puis à rapporter l'ensemble intermédiaire 12 sur le substrat définitif ou substrat d'accueil 10, contrairement à l'art antérieur ou la ou les couches minces sont déposées et traitées sur le substrat d'accueil.

Dans l'exemple non limitatif décrit, dans cette phase du procédé la structure 11 à couches minces est formée par le dépôt de trois couches superposées destinées à constituer, pour chaque tête magnétique, deux pôles séparés par un entrefer microscopique, par opposition à l'entrefer macroscopique que constitue chaque rétrécissement 4 déjà montrés aux figures 1 et 2. Bien entendu, pour réaliser la face active d'une tête magnétique telle que montrée à la figure 2, le substrat intermédiaire 13 pourrait porter une unique couche en matériau magnétique .

Parmi les trois couches minces superposées 14, 15, 16 que porte le substrat intermédiaire 13, la couche du milieu 15 est une couche en un matériau non magnétique (en alumine ou en silice par exemple) destinée à constituer des entrefers microscopiques 20, 20a.

Comme il est montré sur la figure 3, l'ensemble intermédiaire 12 est positionné sur le substrat d'accueil 10 de manière que les entrefers microscopiques 20 soient situés sensiblement sur des axes longitudinaux 21 des encoches 2, les couches minces 14, 15, 16 étant orientées vers les rétrécissement 4 c'est-à-dire vers la face 9 du substrat d'accueil qui communique avec les rétrécissements 4.

Le substrat d'accueil 10 et l'ensemble intermédiaire 12 sont solidarisés l'un à l'autre par un moyen en lui-même classique, par collage par exemple, à l'aide d'un produit de collage tel que de l'epoxy par exemple, ou encore du verre fondu ou pulvérisé. Le produit de collage est disposé entre le substrat d'accueil 10 et l'ensemble intermédiaire 12, et ces derniers sont pressés l'un contre l'autre par des moyens traditionnels (non représentés) jusqu'au moment où le produit de collage constitue une couche intermédiaire 22 relativement peu épaisse, de l'ordre de 5 micromètres par exemple ; cette couche intermédiaire étant assez épaisse cependant pour compenser les défauts de planéité et la rugosité que peut présenter la face 9 du substrat d'accueil après un éventuel polissage sommaire.

Ceci met en évidence un avantage important apporté par le procédé de l'invention, qui réside dans le fait que la couche intermédiaire 22 remplit en plus de sa fonction de collage, une fonction de compensation des défauts de planéités et de rugosité, ce qui évite une étape de polissage de très haute qualité.

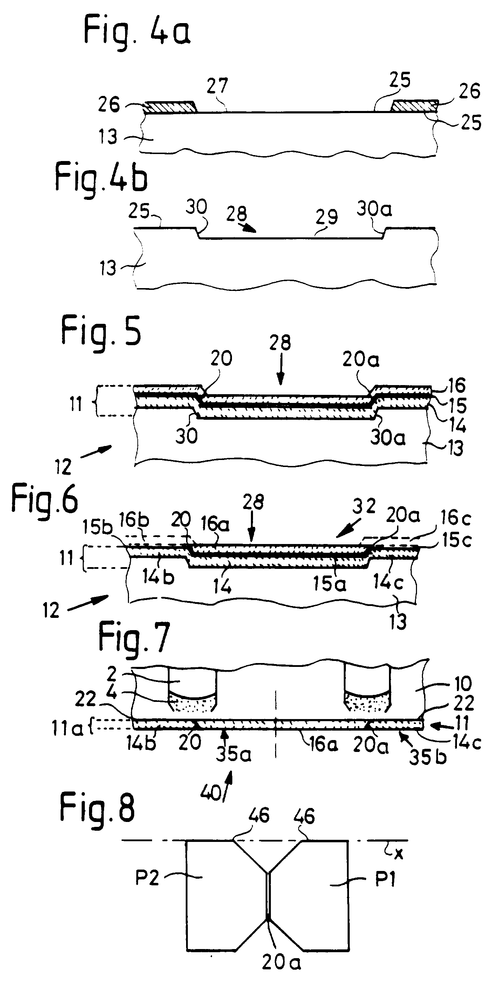

Les figures 4a et 4b illustrent la préparation du substrat intermédiaire 13 en vue d'effectuer sur ce dernier des dépôts de films en couches minces.

Le substrat 13 peut être réalisé en un matériau quelconque, mais de préférence ce matériau doit pouvoir être gravé par les techniques courantes utilisées dans le domaine des dépôts de films en couches minces, notamment par les techniques classiques de masquage et de gravure par voies chimiques. Ce matériau doit également pouvoir supporter les températures (de l'ordre de 500°C par exemple) exigées pour le recuit des couches minces (quand ce recuit est nécessaire), et il doit présenter un coefficient de dilatation compatible avec ceux des couches minces ; en résumé le matériau du substrat intermédiaire 13 est choisi pour être compatible avec les traitements qui peuvent être exigés pour les couches minces.

Aussi, compte tenu de la nature des couches minces (qui est expliquée ci-après), un matériau semiconducteur peut convenir à constituer le substrat intermédiaire 13, le silicium par exemple, ou tout autre type de matériau tel que par exemple le germanium, le verre, etc...

Une face 25 du substrat intermédiaire 13 est éventuellement traitée pour présenter une rugosité maximum de quelques centièmes de micromètres ; une telle rugosité est tout à fait admissible et ne risque pas de dégrader les propriétés des couches minces, et elle peut être obtenue facilement à l'aide de techniques de rectification mécanique classiques.

Les entrefers microscopiques 20, 20a montrés à la figure 3 sont réalisés à l'aide de marches gravées dans le substrat intermédiaire 13, et les marches doivent présenter des flancs bien définis pour réaliser des entrefers aussi rectilignes que possible ; ceci étant obtenu par gravure par voie chimique, mécanique ou autre.

A cet effet, selon une caractéristique du procédé de l'invention, le substrat intermédiaire est constitué en un matériau semiconducteur monocristallin. Par exemple du silicium monocristallin convient très bien, car l'on sait y graver des marches par voies chimiques dont les flancs suivent rigoureusement les axes cristallographiques.

On peut également dans cet esprit, utiliser par exemple de l'arséniure de galium GaAs.

Sur la surface 25 du substrat intermédiaire 13, on dépose de manière traditionnelle un masque 26 de résine, de sorte à laisser apparaître une surface dégagée 27 (figure 4a).

Le silicium du substrat intermédiaire 13 est attaqué dans la surface dégagée 27 selon une technique en elle-même classique, chimique par exemple ; puis la résine du masque 26 est dissoute dans un produit adéquat. Le substrat intermédiaire 13 est alors tel que montré à la figure 4 b, avec un évidement ou surface en creux 28 à l'emplacement où était la surface dégagée 27, le fond 29 de ce creux rejoignant la surface 25 par des marches 30, 30a à flancs pratiquement rectilignes.

On dépose ensuite, sur la surface 25 et le creux 28, les couches minces 14, 15, 16 par une méthode conventionnelle, par pulvérisation cathodique par exemple ou encore par une méthode de dépôt en phase vapeur (CVD) également classique.

La figure 5 montre le substrat intermédiaire 13 quand les couches minces sont déjà déposées sur ces derniers ; c'est-à-dire qu'il supporte la structure 11 à couche mince.

La première couche déposée 14 est une couche en un matériau fortement magnétique tel que par exemple celui connu sous le nom de Sendust (Feₓ Si_{y} Al_{z}) avec une épaisseur comprise entre 1 et 5 micromètres par exemple.

On trouve ensuite, sur la première couche 14, la seconde couche 15 en un matériau non magnétique, qui peut être par exemple de l'alumine ou de la silice. Cette seconde couche 15 en matériau non magnétique est destiné à former les entrefers 20, 20a sur les marches 30, 30a et l'épaisseur de ces entrefers ne dépend que de l'épaisseur de la seconde couche 15 qui peut être comprise par exemple entre 0,1 et 1 micromètre.

Bien entendu sur les figures, l'échelle des dimensions n'est pas respectée pour une meilleure clarté de ces figures.

On trouve ensuite, sur la seconde couche 15, la troisième couche 16 en un matériau magnétique ; la troisième couche 16 est semblable quand à sa nature et à son épaisseur à la première couche 14. On constate que les couches minces 14, 15, 16 épousent parfaitement la forme de l'évidement ou surface en creux 28 réalisée dans le substrat intermédiaire.

Ainsi la première, puis la seconde, puis la troisième couches 14, 15, 16 sont superposées de telle sorte que durant les opérations de dépôt de ces couches, c'est-à-dire depuis le dépôt de la première couche 14 jusqu'au dépôt de la troisième couche 16, il n'est pas nécessaire de sortir l'ensemble intermédiaire 12 de l'enceinte dans laquelle sont effectués ces dépôts. En effet, aucune étape de photolithographie n'est nécessaire entre les dépôts, on s'affranchit ainsi de tous les problèmes dus aux nettoyages des résines, ces nettoyages étant essentiels dans l'art antérieur pour obtenir une bonne adhérence des couches les unes sur les autres.

La figure 6 montre l'ensemble intermédiaire 12 après une opération de polissage, en elle-même classique, qui permet d'éliminer, de chaque côté de l'évidement ou surface en creux 28, des parties 16b, 16c de la troisième couche 16 et des parties 15b, 15c (représentées en traits pointillés) de la seconde couche 15 (non magnétique), de manière à ne laisser subsister, dans cette phase du procédé, que : la première couche 14 entière) ; une partie centrale 15a de la seconde couche (située dans l'évidement 28) et les entrefers 20, 20a formés au droit des marches 30, 30a ; une partie centrale 16a de la troisième couche 16.

Par cette opération on a fait apparaître une face 32 de la structure il à couche mince qui est formée par :
- des parties de côté 14b, 14c de la première couche 14 magnétique situées de part et d'autre de l'évidement 28 ;
- la partie centrale 16a de la troisième couche 16 en matériau magnétique ;
- une extrémité de chaque entrefer 20, 20a qui permet de séparer la partie centrale 16a magnétique (de la troisième couche 16) des parties de côtés 14b, 14c magnétiques (de la première couche 14) ;
- la partie centrale 15a non magnétique étant interposée entre les parties centrales magnétiques 14a, 16a.

Ensuite le substrat d'accueil 10 (ou substrat de fermeture de champ) et l'ensemble intermédiaire 12 sont solidarisés l'un à l'autre comme indiqué en référence à la figure 3.

L'opération suivante consiste à éliminer le substrat intermédiaire 12 par procédé chimique, mécanique ou autre, ainsi qu'à éliminer la partie centrale 14 de la première couche 14 et àéliminer éventuellement en tout ou partie, la partie centrale 15c non magnétique de la seconde couche 15.

On obtient alors, comme montré à la figure 7, le substrat d'accueil 10 portant la structure 11 à couches minces (qui est maintenant limitée à une partie utile 11a) par l'intermédiaire de la couche intermédiaire 22 d'assemblage, la structure 11 étant formée de couches magnétiques 14b, 16a, 14c situées dans un même plan et séparées par des entrefers 20, 20a et formant des faces actives 35a, 35b à l'opposé du substrat d'accueil 10.

Il ne reste alors plus qu'à définir la forme des pôles magnétiques par gravure, sur les faces actives 35a, 35b, comme décrit par exemple dans une demande de brevet français n° 87 14822.

La forme des pôles magnétiques peut être celle représentée àtitre d'exemple non limitatif à la figure 8 qui montre la forme d'un premier et d'un second pôle P1, P2 susceptibles d'être réalisés de chaque côté d'un entrefer 20, 20a, l' entrefer 20a par exemple. Dans ce cas, les pôles P1, P2 sont vus par une vue de dessus telle qu'illustrée par une flèche 40 sur la figure 7 ; le premier pôle P1 étant réalisé dans la couche magnétique de côté 14c et le second pôle P2 dans la couche magnétique centrale 16a.

Pour réaliser la gravure des pôles magnétiques P1, P2 on peut procéder par exemple de la manière ci-après expliquée, manière dont la simplicité permet de ne pas illustrer la méthode :
- on dépose sur les faces actives un revêtement ou résine photosensible ;
- on procède ensuite à un ou des masquages de ce revêtement par un masque ayant la forme et les dimensions que l'on désire conférer aux pôles P1, P2 ;
- le revêtement photosensible masqué est insolé ;
- après élimination des résines et masques, la gravure peut être effectuée par une méthode classique (gravure chimique, gravure ionique, gravure par plasma), pour obtenir les pôles P1, P2. Bien entendu, par cette méthode les pôles P1, P2 émergent par rapport à la surface environnante.

En ce qui concerne la réalisation et/ou le montage du ou des bobinages (non représentés) ceci peut être accompli par exemple comme décrit dans la demande de brevet français n° 86 14975 ; ou encore après découpage ou individualisation de chaque tête magnétique, le ou les bobinages peuvent être bobinés autour d'une branche du circuit magnétique à l'aide des encoches 2, 2a.

La description qui suit se rapporte à une version préférée du procédé de l'invention qui permet d'obtenir des pôles magnétiques encastrés dans le substrat intermédiaire 13, c'est-à-dire qui n'émergent pas par rapport à la surface environnante.

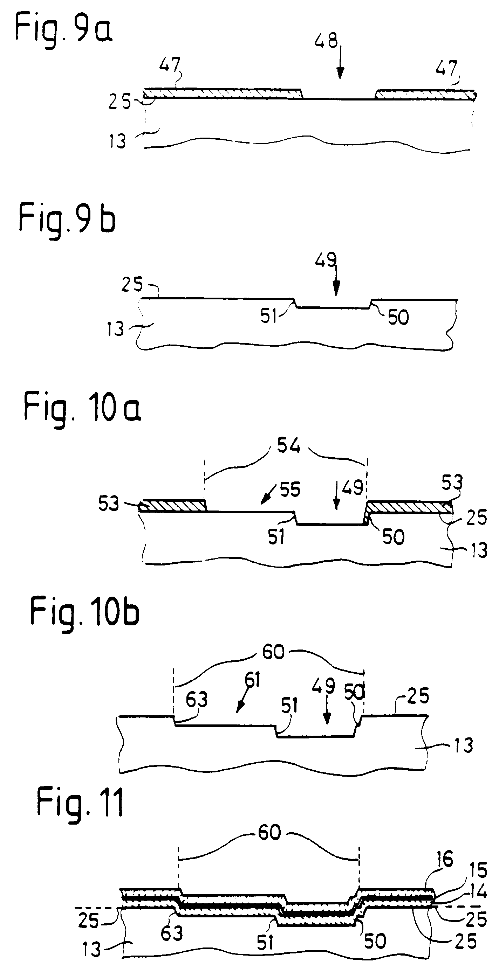

les figures 9a et 9b illustrent des opérations qui permettent d'obtenir dans le substrat intermédiaire 13 l'empreinte d'un pôle magnétique de forme semblable aux pôles magnétiques P1, P2 montrés à la figure 8. Les figures 9a, 9b sont des vues en coupe longitudinale réalisées suivant un axe X montré à la figure 8 et sur lequel sont situés des côtés longitudinaux 46 des pôles P1, P2.

Sur la surface 25 du substrat intermédiaire 13, on réalise un masque 47 qui, après développement, laisse apparaître une surface dégagée 48 ayant la forme d'un pôle magnétique montré à la figure 8 ; cette forme étant représentée sur la figure 9a selon la dimension d'un côté 46 de ce pôle magnétique.

Après attaque par voie chimique par exemple de la surface dégagée 48 et élimination de la résine du masque 47, on obtient dans la surface 25 un évidement 49 ayant la forme d'un pôle magnétique et qui rejoint la surface 25 par des marches 50, 51 rectilignes.

Les figures 10a et 10b illustrent une étape du procédé qui permet de réaliser un autre évidement symétrique au précédent en vue de former le second pôle et en augmentant la profondeur de l'évidement 49 précédent.

A cette fin, un deuxième masque 53, qui a la forme de l'ensemble des deux pôles, est disposé sur la surface 25 du substrat intermédiaire 13, de sorte à définir une nouvelle surface dégagée 54 formée par l'évidement 49 plus une surface dégagée supplémentaire 55 ayant la forme du second pôle magnétique.

Du côté de l'évidement 49 déjà réalisé, et formant un premier motif, la superposition avec le second motif à réaliser doit être aussi bonne que possible, mais ne revêt pas un caractère trop critique : de préférence, le second masque 53 sera plutôt en retrait par rapport au premier, comme illustré sur la figure 10a où il recouvre la marche 50.

On voit sur la figure 10b qu'après attaque de la surface dégagée 54 et élimination du masque 53, à l'emplacement de la surface dégagée 54 est constitué, dans la surface 25 du substrat intermédiaire 13, un caisson 60 à double profondeur. Le caisson 60 est constitué par l'évidement 49, dont la profondeur a augmenté, et par un évidement 61 qui remplace la dernière surface dégagée 55, et qui d'une part, rejoint la surface 25 par une nouvelle marche 63, et d'autre part, rejoint le fond de l'évidement 49 par la marche 51 ou marche intermédiaire située sensiblement au milieu du caisson 60.

La figure 11 montre le support intermédiaire 13 sur lequel ont été déposées, et particulièrement dans le caisson 60, les trois couches minces 14, 15, 16 qui sont superposées comme dans l'exemple précédent, et qui épousent la forme des marches 63, 51, 50.

Une opération suivante consiste à éliminer les parties de ces couches minces qui ne sont pas contenues dans le caisson 60. Ceci peut être obtenu comme dans l'exemple précédent par une opération de polissage qui élimine toute matière en dépassement par rapport à la surface 25 du substrat intermédiaire 13, laquelle surface 25 est matérialisée par une ligne en traits pointillés sur la figure 11.

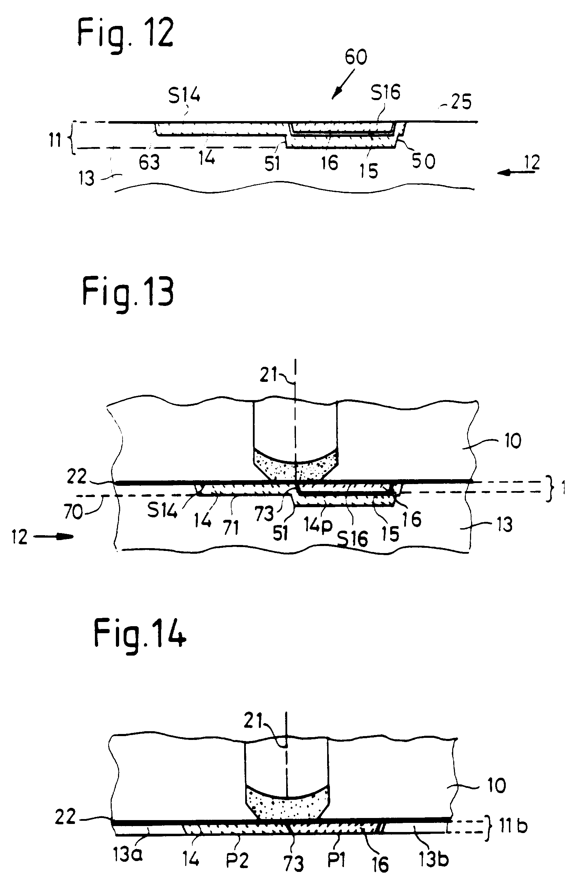

Comme représenté à la figure 12, il résulte de cette opération de polissage que l'on fait apparaître dans un même plan que la surface 25, les surfaces S14 et S16 des couches 14 et 16 en matériau magnétique situées dans le caisson 60. La seconde couche mince 15 non magnétique sépare ces deux couches magnétiques 14, 16, et cette seconde couche 15 non magnétique apparaît par ses extrémités situées au niveau de la marche 50 et de la marche intermédiaire 51.

Il a ainsi été réalisé l'ensemble intermédiaire 12 qui peut être solidarisé au substrat d'accueil 10 d'une même manière que dans l'exemple précédent. Bien entendu à la différence du cas précédent, dans cette version de l'invention, la forme des pôles magnétiques P1, P2 est déjà gravée dans les couches magnétiques 14, 16.

La figure 13 montre le substrat d'accueil 10 solidarisé à l'ensemble intermédiaire 12 à l'aide de la couche intermédiaire 22, et avec les surfaces 25, S14, S15 orientées vers le substrat d'accueil 10, et la marche intermédiaire 51 sensiblement centrée sur l'axe 21 de l'encoche 2. La seconde couche 15 non magnétique formant à cet endroit une marche destinée à constituer un entrefer 73.

Une étape suivante du procédé de l'invention consiste à éliminer partiellement le support intermédiaire 13 ainsi qu'une partie de la première couche magnétique 14 située au niveau le plus profond dans le substrat intermédiaire 12, cette partie de couche magnétique profonde étant repérée 14P sur la figure 13. En fait dans cette opération, on élimine toute matière située au-delà d'un plan, représenté par une ligne en traits pointillés 70, qui correspond à une surface inférieure 71 de la première couche 14 dans la partie où celle-ci est conservée, c'est-à-dire à l'opposé de la surface S14 ; d'où il résulte que l'on conserve de la structure il uniquement une partie utile 11b.

La figure 14 illustre le résultat de cette opération. On voit que la partie de structure utile 11b à couches minces est solidarisée au substrat d'accueil 10 et que, à la différence de la version précédente, les deux pôles magnétiques P1, P2 sont déjà formés, représentés respectivement par une partie de la première couche 14 et une partie de la troisième couche 16. Les deux pôles P1, P2 sont séparés par un entrefer microscopique 73 qui résulte de la deuxième couche 15 non magnétique.

On constate en outre que dans cette version du procédé de l'invention, les pôles magnétiques P1, P2 sont encastrés entre les parties restantes 13a, 13b du substrat 13 de sorte que la surface active est cette fois parfaitement plane.

## Revendications

1. Procédé pour réaliser un dispositif destiné à constituer au moins une tête magnétique, ledit dispositif comportant une structure (11, 11a) du type à couches minces déposées, ladite structure (11, 11a) à couches minces déposées comportant au moins une couche mince déposée en matériau magnétique (14, 15, 16), ladite structure (11, 11a) étant portée par un substrat d'accueil (10), le procédé consistant à réaliser le dépôt de la couche mince (14, 16) sur un substrat intermédiaire (13) pour réaliser un ensemble intermédiaire (12) à couches minces déposées, puis à rapporter l'ensemble intermédiaire (12) sur le substrat d'accueil (10) de manière à solidariser ce dernier à l'ensemble intermédiaire (12), aucune couche mince n'étant déposée sur le substrat intermédiaire quand ce dernier est solidaire du substrat d'accueil, le procédé étant caractérisé en ce que cette dernière étape est effectuée de telle sorte que ladite couche mince (14, 15, 16) soit située du côté du substrat d'accueil (10), et en ce qu'il consiste ensuite à éliminer au moins partiellement le substrat intermédiaire (13) et à ne laisser subsister qu'une partie utile (11, 11b) de l'ensemble intermédiaire (12).

2. Procédé selon la revendication 1, caractérisé en ce qu'il consiste à solidariser l'ensemble intermédiaire (12) et le substrat d'accueil (10) à l'aide d'un produit de collage formant une couche intermédiaire (22) entre l'ensemble intermédiaire (12) et le substrat d'accueil (10), la couche intermédiaire (22) ayant une épaisseur appropriée à compenser des défauts de planéité ou de rugosité présentés par le substrat d'accueil (10).

3. 3 Procédé selon la revendication 1, caractérisé en ce que le substrat d'accueil (10) comporte au moins un circuit magnétique, et en ce qu'au moins une couche mince (14, 16) en matériau magnétique est déposée sur le substrat intermédiaire (13) en vue de former des pôles magnétiques (P1, P2).

4. Procédé selon la revendication 3, caractérisé en ce qu'il consiste à réaliser au moins un évidement (28) dans une face (25) du substrat intermédiaire (13), puis à déposer sur la face (25) du substrat intermédiaire (13) et dans l'évidement (28) au moins trois couches minces (14, 15, 16) superposées, la première couche (14) qui est en contact avec le substrat intermédiaire (13) étant une couche d'un matériau magnétique, la seconde couche (15) déposée sur la première étant en un matériau non magnétique, la troisième couche (16) déposée sur la seconde couche étant en un matériau magnétique, les décrochements entre la face (25) et l'évidement (28) constituant des marches (30, 30a) dont la forme est épousée par les couches minces, le procédé consistant en outre à usiner l'ensemble intermédiaire (12) du côté de la troisième couche (16) de manière à éliminer des parties (16b, 16c) de cette dernière situées à l'extérieur de l'évidement (28), et à éliminer éventuellement des parties périphériques 15b, 15c de la seconde couche non magnétique située à l'extérieur de l'évidement (28), de manière à former une face sensiblement plane (32) et à faire apparaître sur cette face plane au moins une extrémité (20, 20a) de la seconde couche (15) située au regard d'une marche (30, 30a), chaque extrémité 20, 20a constituant un entrefer qui sépare deux couches magnétiques dont l'une est formée par une partie de la première couche (14) et l'autre par une partie de la troisième couche (16), l'ensemble intermédiaire (12) étant solidarisé au substrat d'accueil (10) par la face plane (32).

5. Procédé selon la revendication 4, caractérisé en ce qu'il consiste, après avoir solidarisé le substrat d'accueil (10) et l'ensemble intermédiaire (12), à usiner l'ensemble intermédiaire (12) du côté opposé au substrat d'accueil (10) de manière à éliminer le substrat intermédiaire (13) et une partie centrale de la première couche magnétique (14), cette partie centrale étant située dans l'évidement (28) de sorte que les parties restantes de la première et de la troisième couches magnétiques (14, 16) sont dans un même plan, et en ce qu'il consiste ensuite à graver lesdites parties restantes de sorte à constituer au moins deux pôles magnétiques (P1, P2) séparés par un entrefer (20, 20a).

6. Procédé selon l'une des revendications précédentes, caractérisé en ce que, pour réaliser le substrat intermédiaire (13), il consiste à utiliser un matériau semiconducteur de type monocristallin .

7. Procédé selon la revendication 6, caractérisé en ce que le substrat intermédiaire (13) est en silicium.

8. Procédé selon la revendication 1, caractérisé en ce qu'il consiste à réaliser à la surface (25) du substrat intermédiaire un caisson (60) à double profondeur formé par un premier évidement (49) et un second évidement (61) moins profond que le premier, les deux évidements étant séparés par une marche intermédiaire (51) ; le procédé consistant ensuite à déposer sur le caisson (60) une première, une deuxième, et une troisième couches minces (14, 15, 16) respectivement magnétique, non magnétique et magnétique ; puis ensuite à éliminer toute matière se trouvant en dépassement par rapport à la surface (25) du substrat intermédiaire ; puis à fixer sur le substrat d'accueil (10), par cette surface (25), l'ensemble intermédiaire ainsi obtenu; puis à araser une partie du substrat intermédiaire et de la première couche (14) magnétique de manière à ne laisser subsister de l'ensemble intermédiaire (12) qu'une partie utile (11b) formée d'une partie de la première couche magnétique (14) et d'une partie de la troisième couche magnétique (16), ces deux couches magnétiques (14, 16) étant séparées par un entrefer (73) constitué au-dessus de la marche intermédiaire (51) par une partie restante de la seconde couche (15) non magnétique, les deux parties de couches magnétiques (14, 16) formant des pôles magnétiques (P1, P2) encastrés dans des parties (13a, 13b) non éliminées du substrat intermédiaire (13).

## Patentansprüche

1. Verfahren zur Herstellung einer Vorrichtung, die mindestens einen Magnetkopf bilden soll, wobei die Vorrichtung eine Struktur (11, 11a) mit dünnen Schichten besitzt, die mindestens eine aufgebrachte dünnen Schicht aus magnetischem Material (14, 15, 16) besitzt, wobei die Struktur (11, lla) auf einem Stammsubstrat (10) liegt und das Verfahren darin besteht, die dünne Schicht (14, 16) auf ein Zwischensubstrat (13) zur Herstellung einer Dünnschicht-Zwischeneinheit (12) aufzubringen, dann die Zwischeneinheit (12) auf das Stammsubstrat (10) so aufzusetzen, daß sie miteinander fest verbunden werden, wobei keine dünne Schicht auf das Zwischensubstrat aufgebracht wird, nachdem letzteres mit dem Stammsubstrat verbunden wurde, dadurch gekennzeichnet, daß dieser letztgenannte Verfahrensschritt so durchgeführt wird, daß die dünne Schicht (14, 15, 16) sich auf der dem Stammsubstrat zugewandten Seite befindet, und daß dann zumindest teilweise das Zwischensubstrat (13) entfernt wird und nur ein Nutzteil (11, 11b) der Zwischeneinheit (12) übrigbleibt.

2. Verfahren nach Anspruch 1, dadurch gekennzeichnet, daß die Zwischeneinheit (12) und das Stammsubstrat (10) mit Hilfe eines Klebers vereint werden, der eine Zwischenschicht (22) zwischen der Zwischeneinheit (12) und dem Stammsubstrat (10) bildet, wobei diese Zwischenschicht (22) eine geeignete Dicke hat, um die Planfehler oder die Rauhigkeit der Oberfläche des Stammsubstrats (10) auszugleichen.

3. Verfahren nach Anspruch 1, dadurch gekennzeichnet, daß das Stammsubstrat (10) mindestens einen Magnetkreis besitzt und daß mindestens eine dünne Schicht (14, 16) aus magnetischem Material auf das Zwischensubstrat (13) aufgebracht wird, um Magnetpole (P1, P2) zu bilden.

4. Verfahren nach Anspruch 3, dadurch gekennzeichnet, daß es darin besteht, mindestens eine Vertiefung (28) in einer Seite (25) des Zwischensubstrats (13) vorzusehen, dann auf diese Seite (25) des Zwischensubstrats (13) und in die Vertiefung (28) mindestens drei dünne Schichten (14, 15, 16) übereinander aufzubringen, wobei die erste Schicht (14), die mit dem Zwischensubstrat (13) in Kontakt steht, eine Schicht aus magnetischem Material, die zweite Schicht (15), die auf der ersten liegt, eine Schicht aus einem unmagnetischen Material und die dritte Schicht (16), die auf der zweiten liegt, eine Schicht aus magnetischem Material ist, wobei die Übergänge zwischen der Seite (25) und der Vertiefung (28) Stufen (30, 30a) bilden, deren Form von den dünnen Schichten ausgekleidet wird, worauf die Zwischeneinheit (12) an der Seite der dritten Schicht (16) so abgeschliffen wird, daß Bereiche (16b, 16c) dieser letztgenannten Schicht außerhalb der Vertiefung (28) und ggf. periphere Bereiche (15b, 15c) der zweiten, unmagnetischen Schicht außerhalb der Vertiefung (28) entfernt werden, so daß sich eine im wesentlichen ebene Seite (32) ergibt, auf der mindestens ein Ende (20, 20a) der zweiten Schicht (15) in Höhe einer Stufe (30, 30a) zutagetritt, die einen Magnetspalt bildet, der zwei Magnetschichten voneinander trennt, von denen eine durch einen Teil der ersten Schicht (14) und die andere durch einen Teil der dritten Schicht (16) gebildet wird, worauf die Zwischeneinheit (12) mit dem Stammsubstrat (10) über die ebene Seite (32) vereint wird.

5. Verfahren nach Anspruch 4, dadurch gekennzeichnet, daß nach der Vereinigung des Stammsubstrats (10) und der Zwischeneinheit (12) die Zwischeneinheit (12) auf der dem Stammsubstrat (10) abgewandten Seite abgeschliffen wird, so daß das Zwischensubstrat (13) und ein zentraler Teil der ersten Magnetschicht (14) in der Vertiefung (28) entfernt werden und die verbleibenden Teile der ersten und dritten Magnetschichten (14, 16) in einer gemeinsamen Ebene liegen, und daß dann die verbleibenden Teile selektiv geätzt werden, um mindestens zwei Magnetpole (P1, P2) zu formen, die durch einen Magnetspalt (20, 20a) voneinander getrennt sind.

6. Verfahren nach einem der vorhergehenden Ansprüche, dadurch gekennzeichnet, daß zur Herstellung des Zwischensubstrats (13) ein Halbleitermaterial vom monokristallinen Typ verwendet wird.

7. Verfahren nach Anspruch 6, dadurch gekennzeichnet, daß das Zwischensubstrat (13) aus Silizium ist.

8. Verfahren nach Anspruch 1, dadurch gekennzeichnet, daß an der Oberfläche (25) des Zwischensubstrats eine Vertiefung (60) doppelter Tiefe gebildet wird, die von einer ersten Vertiefung (49) und einer weniger tiefen zweiten Vertiefung (61) gebildet wird, wobei die beiden Vertiefungen über eine Zwischenstufe (51) ineinander übergehen, daß dann nacheinander in der Vertiefung (60) eine erste, magnetische Schicht (14), eine zweite, unmagnetische Schicht (15) und eine dritte dünne Schicht (16) aus magnetischem Material aufgebracht werden, daß dann alles Material jenseits der Oberfläche (25) des Zwischensubstrats entfernt wird, daß dann die so erhaltene Zwischeneinheit auf dem Stammsubstrat (10) über diese Oberfläche (25) befestigt wird, daß dann ein Teil des Zwischensubstrats und der ersten Magnetschicht (14) abgeschliffen wird, so daß von der Zwischeneinheit (12) nur noch ein Nutzteil (11b) bestehend aus einem Teil der ersten Magnetschicht (14) und einem Teil der dritten Magnetschicht (16) übrigbleibt, die durch einen oberhalb der Zwischenstufe (51) verbleibenden Teil der zweiten, unmagnetischen Schicht (15) voneinander getrennt sind, die einen Magnetspalt (73) bildet, wobei die beiden Teile von Magnetschichten (14, 16) Magnetpole (P1, P2) bilden, die in die nicht entfernten Teile (13a, 13b) des Zwischensubstrats (13) eingelassen sind.

## Claims

1. Process for making a device intended to form at least one magnetic head, the said device including a structure (11, 11a) of the deposited thin film type, the said deposited thin-film structure (11, 11a) including at least one deposited thin film (14, 15, 16) of magnetic material, the said structure (11, 11a) being supported by a host substrate (10), the process consisting in depositing the thin film (14, 16) on an intermediate substrate (13) in order to produce an intermediate deposited thin-film assembly (12), then in attaching the intermediate assembly (12) onto the host substrate (10) so as to join the latter integrally into the intermediate assembly (12), no thin film being deposited on the intermediate substrate when the latter is integrally joined to the host substrate, the process being characterized in that the latter step is carried out in such a way that the said thin film (14, 15, 16) is located on the side of the host substrate (10), and in that it consists in then at least partially eliminating the intermediate substrate (13) and in leaving only a functional part (11, 11b) of the intermediate assembly (12) to remain.

2. Process according to Claim 1, characterized in that it consists in integrally joining the intermediate assembly (12) and the host substrate (10) using an adhesive product forming an intermediate layer (22) between the intermediate assembly (12) and the host substrate (10), the intermediate layer (22) having a suitable thickness for compensating for irregularities or surface roughness defects on the host substrate (10).

3. Process according to Claim 1, characterized in that the host substrate (10) includes at least one magnetic circuit, and in that at least one thin film (14, 16) of magnetic material is deposited on the intermediate substrate (13) with a view to forming the magnetic poles (P1, P2).

4. Process according to Claim 3, characterized in that it consists in making at least one hollow (28) in one face (25) of the intermediate substrate (13), then in depositing at least three superposed thin films (14, 15, 16) on the face (25) of the intermediate substrate (13) and in the hollow (28), the first film (14) which is in contact with the intermediate substrate (13) being a film of a magnetic material, the second film (15) deposited on the first being made of a nonmagnetic material, the third film (16) deposited on the second film being made of a magnetic material, the discontinuities between the face (25) and the hollow (28) constituting stairs (30, 3a), the shape of which is matched by the thin films, the process furthermore consisting in machining the intermediate assembly (12) on the side of the third film (16) so as to eliminate parts (16b, 16c) of the latter which lie outside the hollow (28), and optionally to eliminate peripheral parts 15b, 15c of the second, nonmagnetic layer which is located outside the hollow (28), so as to form a substantially plane face (32) and to cause at least one end (20, 20a) of the second film (15), located opposite a stair (30, 30a), to appear on this plane face, each end 20, 20a constituting an air gap which separates two magnetic films, one of which is formed by a part of the first film (14) and the other by a part of the third film (16), the intermediate assembly (12) being integrally joined to the host substrate (10) by the plane face (32).

5. Process according to Claim 4, characterized in that it consists, after having joined the host substrate (10) and the intermediate assembly (12) integrally, in machining the intermediate assembly (12) on the side opposite the host substrate (10), so as to eliminate the intermediate substrate (13) and a central part of the first magnetic film (14), this central part being located in the hollow (28), so that the remaining parts of the first and of the third magnetic films (14, 16) are in one and the same plane, and in that it consists in then etching the said remaining parts so as to form at least two magnetic poles (P1, P2) separated by an air gap (20, 20a).

6. Process according to one of the preceding claims, characterized in that in order to make the intermediate substrate (13), it consists in using a semiconductor material of monocristalline type.

7. Process according to Claim 6, characterized in that the intermediate substrate (13) is made of silicon.

8. Process according to Claim 1, characterized in that it consists in making at the surface (25) of the intermediate substrate a dual-level compartment (60) formed by a first hollow (49) and a second hollow (61) which is shallower than the first, the two hollows being separated by an intermediate stair (51); the process consisting in then depositing on the compartment (60) a first, a second and a third thin film (14, 15, 16), respectively magnetic, nonmagnetic and magnetic; then in next eliminating any material protruding from the surface (25) of the intermediate substrate; then in fixing on the host substrate (10), via this surface (25), the intermediate assembly thus obtained; then in levelling a part of the intermediate substrate and of the first, magnetic film (14) so as to leave remaining from the intermediate assembly (12) only a functional part (llb) formed by a part of the first, magnetic film (14) and by a part of the third, magnetic film (16), these two magnetic films (14, 16) being separated by an air gap (73) consisting above the intermediate stair (51) of a residual part of the second, nonmagnetic film (15), the two magnetic film parts (14, 16) forming magnetic poles (P1, P2) embedded in the parts (13a, 13b) not eliminated from the intermediate substrate (13).
